# EUROPEAN PATENT SPECIFICATION

(11) **EP 2 743 991 B1**
(45) Date of publication and mention of the grant of the patent: **27.06.2018**
(21) Application number: 13197340.6
(22) Date of filing: 16.12.2013
(51) Int. Cl.: H01L 31/0224, H01L 31/068

(54) **Solar cell and solar cell module**
Solarzelle und Solarzellenmodul
Cellule solaire et module de cellule solaire

(30) Priority: 17.12.2012 TW 101147800
(43) Date of publication of application: 18.06.2014
(73) Proprietor: Motech Industries Inc., 22204 New Taipei City (TW)
(72) Inventor: Lai, Cheng-Hao, Tainan City 74145 (TW); Chen, Wei-Yu, Chiayi City 60096 (TW); Chen, Che-Hung, Tainan City 74145 (TW); Liu, Yen-Chih, Kaohsiung City 80768 (TW); Chang, Kuan-Lun, Tainan City (TW)
(74) Representative: Lang, Christian

(56) References cited:
- JP-A- H09 283 781
- JP-A- H11 298 019

## Description

This invention relates to a solar cell and a solar cell module, more particularly to a solar cell including a front electrode layer having first and second finger bars that extend between two adjacent bus bars and that are spaced apart from each other by a spacing in the front electrode layer.

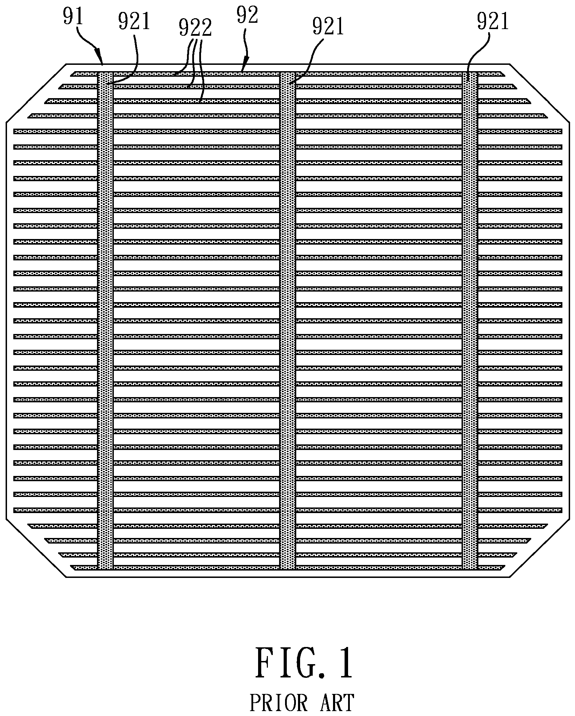

Fig. 1 illustrates a conventional solar cell that includes a semiconductor substrate 91 of a silicone wafer, a front electrode layer 92 formed on a light-receiving surface of the semiconductor substrate 91, and a back electrode layer (not shown). The front electrode layer 92 includes a plurality of bus bars 921 and a plurality of finger bars 922 that are connected to and are transverse to the bus bars 921. Formation of the front electrode layer 92 is conducted by screen printing a conductive paste on the silicon wafer, followed by sintering the conductive paste.

It is desirable to minimize an area of the light-receiving surface that is covered by the finger bars for enhancing the photo-electro conversion efficiency of the solar cell. One way of minimizing the area may be accomplished by increasing an aspect ratio (the ratio of the height to the width) of the finger bars 922, i.e., increasing the height of the finger bars 922 and/or reducing the width of the finger bars 922. However, it is relatively difficult to form a continuous finger bar 922 with a narrow width and a long length by screen printing and sintering, and breaking of the finger bar 922 is likely to occur during screen printing and sintering. Such breakage may reduce the current collecting ability of the finger bars 922 and result in an undesired dark area and a non-uniform brightness at the vicinity of the breakage during electroluminescence inspection of the solar cell. Hence, there is a need to solve the breaking problem of the finger bars 922. Japanese patent JP H09 283781 discloses an alternative geometry of the electrodes in which the light-receiving surface that is covered by the finger bars is reduced.

Therefore, an object of the present invention is to provide a solar cell and a solar cell module that can overcome the aforesaid drawback associated with the prior art.

According to a first aspect of this invention, there is provided a solar cell that comprises: a semiconductor substrate having a light-receiving surface and a back surface opposite to the light-receiving surface; a back electrode layer disposed on the back surface; and a front electrode layer disposed on the light-receiving surface and including a first bus bar, a second bus bar, a plurality of first finger bar units, a plurality of second finger bar units, a plurality of first interconnecting bars, and a plurality of second interconnecting bars. The first and second bus bars extend in a first direction, and are aligned with and are spaced apart from each other in a second direction that is transverse to the first direction. The first and second finger bar units are disposed between the first and second bus bars. The first finger bar units are aligned with one another in the first direction. The second finger bar units are aligned with one another in the first direction. The first finger bar units are spaced apart from the second finger bar units. Each of the first finger bar units has a plurality of first finger bars and a first auxiliary bar. The first finger bars are connected to the first bus bar, and extend therefrom toward the second bus bar. Each of the first finger bars has a first end that is connected to the first bus bar, and a second end that is opposite to the first end. The first auxiliary bar interconnects the second ends of the first finger bars. Each of the second finger bar units has a plurality of second finger bars and a second auxiliary bar. The second finger bars are connected to the second bus bar, and extend therefrom toward the first bus bar. Each of the second finger bars has a first end that is connected to the second bus bar, and a second end that is opposite to the first end of the second finger bar. The second auxiliary bar interconnects the second ends of the second finger bars. Each of the first interconnecting bars interconnects two adjacent ones of the first finger bar units, and is spaced apart from the first bus bar in the second direction by a distance less than the distance between each of the first auxiliary bars and the first bus bar in the second direction. Each of the second interconnecting bars interconnects two adjacent ones of the second finger bar units, and is spaced apart from the second bus bar in the second direction by a distance less than the distance between each of the second auxiliary bars and the second bus bar in the second direction.

According to a second aspect of this invention, there is provided a solar cell module that comprises: opposite first and second panels that are spaced apart from each other; at least one solar cell as defined in the first aspect of this invention, the solar cell being disposed between the first and second panels; and an enclosure disposed between the first and second panels and enclosing the solar cell.

According to a third aspect of this invention, there is provided a solar cell that comprises: a semiconductor substrate having a light-receiving surface and a back surface opposite to the light-receiving surface; a back electrode layer disposed on the back surface; and a front electrode layer disposed on the light-receiving surface and including a first bus bar, a second bus bar, at least one first finger bar unit, at least one second finger bar unit, at least one first inner interconnecting bar, and at least one second inner interconnecting bar. The first and second bus bars extend in a first direction, and are aligned with and are spaced from each other in a second direction that is transverse to the first direction. The first and second finger bar units are disposed between the first and second bus bars, and are spaced apart from each other. The first finger bar unit has a plurality of first finger bars and a first auxiliary bar. The first finger bars are connected to the first bus bar, and extend therefrom toward the second bus bar. Each of the first finger bars has a first end that is connected to the first bus bar, and a second end that is opposite to the first end. The first auxiliary bar interconnects the second ends of the first finger bars. The second finger bar unit has a plurality of second finger bars and a second auxiliary bar. The second finger bars are connected to the second bus bar, and extend therefrom toward the first bus bar. Each of the second finger bars has a first end that is connected to the second bus bar, and a second end that is opposite to the first end of the second finger bar. The second auxiliary bar interconnects the second ends of the second finger bars. The first inner interconnecting bar interconnects two adjacent ones of the first finger bars, and is spaced apart from the first bus bar in the second direction by a distance less than the distance between the first auxiliary bar and the first bus bar in the second direction. The second inner interconnecting bar interconnects two adjacent ones of the second finger bars and is spaced apart from the second bus bar in the second direction by a distance less than the distance between the second auxiliary bar and the second bus bar in the second direction.

According to a fourth aspect of this invention, there is provided a solar cell module that comprises: opposite first and second panels that are spaced apart from each other; at least one solar cell as defined in the third aspect of this invention, the solar cell being disposed between the first and second panels; and an enclosure disposed between the first and second panels and enclosing the solar cell.

In drawings which illustrate embodiments of the invention,
Fig. 1 is a schematic view of a conventional solar cell;
Fig. 2 is a fragmentary sectional view of the first preferred embodiment of a solar cell module according to the present invention;
Fig. 3 is a schematic view showing the configuration of a front electrode layer of a solar cell of the first preferred embodiment;
Fig. 4 is a fragmentary sectional view of the solar cell of the first preferred embodiment taken along line A-A in Fig. 3;
Fig. 5 is a fragmentary schematic view of the first preferred embodiment;
Fig. 6 is a schematic view of the solar cell of the second preferred embodiment of the solar cell module according to the present invention;
Fig. 7 is a schematic view of the solar cell of the third preferred embodiment of the solar cell module according to the present invention;
Fig. 8 is a schematic view of the solar cell of the fourth preferred embodiment of the solar cell module according to the present invention;
Fig. 9 is a fragmentary schematic view of the solar cell of the fourth preferred embodiment;
Fig. 10 is a schematic view of the solar cell of the fifth preferred embodiment of the solar cell module according to the present invention; and
Fig. 11 is a schematic view of the solar cell of the sixth preferred embodiment of the solar cell module according to the present invention.

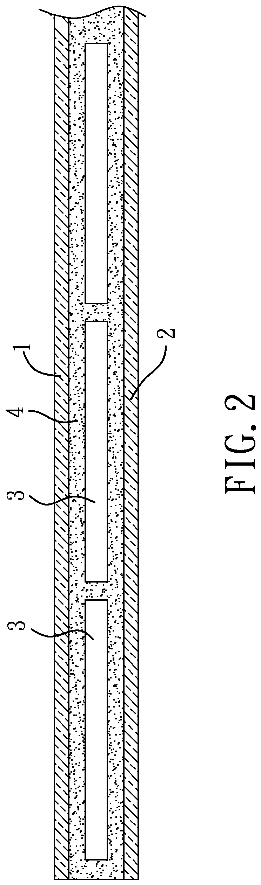

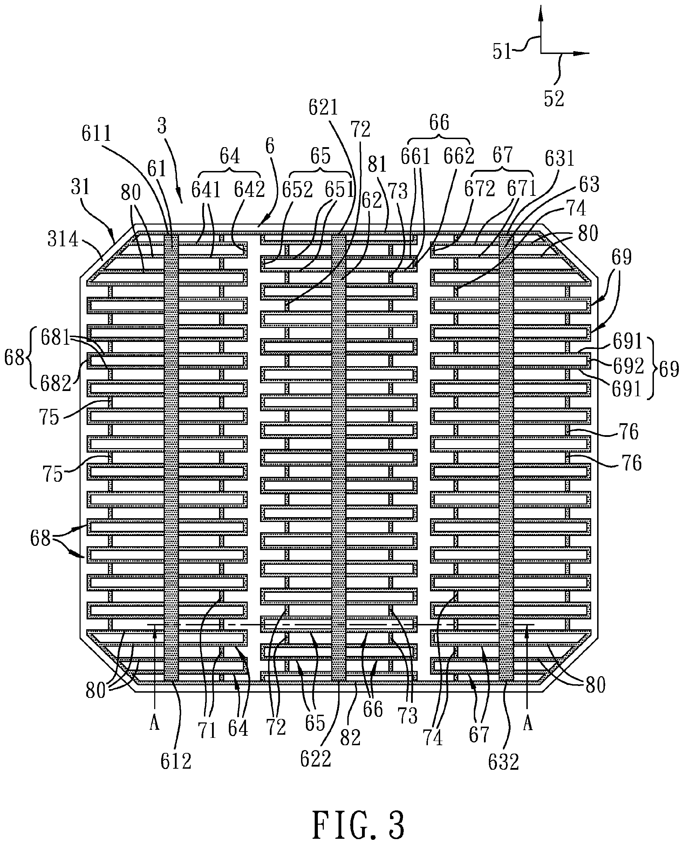

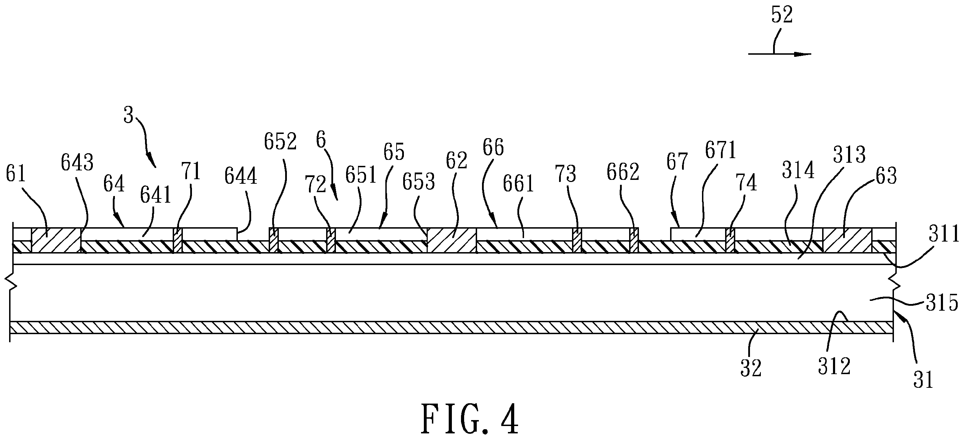

Figs. 2 to 4 illustrate the first preferred embodiment of a solar cell module according to the present invention. The solar cell module includes: opposite first and second panels 1, 2 that are spaced apart from each other; a plurality of solar cells 3 disposed between the first and second panels 1, 2 and arranged in an array; and an enclosure 4 disposed between the first and second panels 1, 2 and enclosing the solar cells 3.

The first and second panels 1, 2 may be made from a material, such as glass or a plastic material. One of the first and second panels 1, 2 is required to be light transmissible for transmission of an incident light to a light receiving side of the solar cells 3. The enclosure may be made from a light transmissible material, such as ethylene vinyl acetate (EVA).

The solar cells 3 are electrically connected to one another through solder ribbons (not shown), and have the same structure.

Each of the solar cells 3 includes a semiconductor substrate 31 of a crystalline silicon, a back electrode layer 32, and a front electrode layer 6.

The semiconductor substrate 31 has a light-receiving surface 311, a back surface 312 opposite to the light-receiving surface 311, a base layer 315 which defines the back surface 312, and an emitter layer 313 which defines the light-receiving surface 311 and which is formed by doping a dopant in the semiconductor substrate 31. An anti-reflection layer 314 is formed on the emitter layer 313. One of the base layer 315 and the emitter layer 313 is made of an n-type semiconductor material, while the other is made of a p-type semiconductor material. The base layer 315 and the emitter layer 313 cooperatively form a pn junction therebetween. The anti-reflection layer 314 may be made from SiNₓ, and serves to reduce the portion of an incident light that is reflected from the solar cell 3, thereby increasing the portion that enters into the emitter layer 313.

The back electrode layer 32 is disposed on the back surface 312 of the semiconductor substrate 31, and cooperates with the front electrode layer 6 to allow the current generated from the solar cell 3 to flow out to an external device (not shown).

The front electrode layer 6 is disposed on the light-receiving surface 311, extends through the anti-reflection layer 314 to contact the emitter layer 313, and includes a first bus bar 61, a second bus bar 62, a third bus bar 63, a plurality of first finger bar units 64, a plurality of second finger bar units 65, a plurality of third finger bar units 66, a plurality of fourth finger bar units 67, a plurality of fifth finger bar units 68, a plurality of sixth finger bar units 69, a plurality of first interconnecting bars 71, a plurality of second interconnecting bars 72, a plurality of third interconnecting bars 73, a plurality of fourth interconnecting bars 74, a plurality of fifth interconnecting bars 75, and a plurality of sixth interconnecting bars 76.

The first, second and third bus bars 61, 62, 63 extend in a first direction 51, and are aligned with and are spaced apart from one another in a second direction 52 that is transverse to the first direction 51. The first and second finger bar units 64, 65 are disposed between the first and second bus bars 61, 62. The third and fourth finger bar units 66, 67 are disposed between the second and third bus bars 62, 63. The fifth finger bar units 68 are connected to the first bus bar 61, and extend therefrom in a direction away from the second bus bar 62. The sixth finger bar units 69 are connected to the third bus bar 63, and extend therefrom in a direction away from the second bus bar 62. Alternatively, the number of the bus bars may be reduced to two. As such, the number of the finger bar units are correspondingly decreased.

In this embodiment, the first finger bar units 64 are aligned with one another in the first direction 51. The second finger bar units 65 are aligned with one another in the first direction 51.

Each of the first finger bar units 64 has a plurality of first finger bars 641 and a first auxiliary bar 642. In this embodiment, the number of the first finger bars 641 of each first finger bar unit 64 is two. Alternatively, the number of the first finger bars 641 of each first finger bar unit 64 may be greater than two. The first finger bars 641 are connected to the first bus bar 61, extend therefrom in the second direction 52 toward the second bus bar 62, and are spaced apart from and are aligned with each other in the first direction 51. Each of the first finger bars 641 has a first end 643 that is connected to the first bus bar 61, and a second end 644 that is opposite to the first end 643. The first auxiliary bar 642 of each first finger bar unit 64 interconnects the second ends 644 of the first finger bars 641 of said each first finger bar unit 64. It is noted that the first auxiliary bar 642 of each first finger bar unit 64 extends in the first direction 51 and connects the second ends 644 of all of the first finger bars 641 of each first finger bar unit 64 regardless of what the number of the first finger bars 641 of each first finger bar unit 64 is. With the inclusion of the first auxiliary bar 642 in each first finger bar unit 64, a conductive network of the first finger bar units 64 can be established and the current collecting efficiency can be enhanced.

Each of the second finger bar units 65 has a plurality of second finger bars 651 and a second auxiliary bar 652. In this embodiment, the number of the second finger bars 651 of each second finger bar unit 65 is two. Alternatively, the number of the second finger bars 651 of each second finger bar unit 65 may be greater than two. The second finger bars 651 of each second finger bar unit 65 are connected to the second bus bar 62, extend therefrom in the second direction 52 toward the first bus bar 61, and are spaced apart from and are aligned with each other in the first direction 51. Each of the second finger bars 651 has a first end 653 that is connected to the second bus bar 62, and a second end 654 that is opposite to the first end 653 of the second finger bar 65. The second auxiliary bar 652 interconnects the second ends 654 of the second finger bars 651. It is noted that the second auxiliary bar 652 of each second finger bar unit 65 extends in the first direction 51 and connects the second ends 654 of all of the second finger bars 651 of each second finger bar unit 65 regardless of what the number of the second finger bars 651 of each second finger bar unit 65 is. With the inclusion of the second auxiliary bar 652 in each second finger bar unit 65, a conductive network of the second finger bar units 65 can be established and the current collecting efficiency of the solar cell 3 can be enhanced.

In this embodiment, the first finger bar units 64 are spaced apart from the second finger bar units 65. More specifically, the second ends 644 of the first finger bar units 64 are spaced apart from the second ends 654 of the second finger bar units 65 in the second direction 52 by a spacing in the front electrode layer 6.

In this embodiment, the first auxiliary bars 642 of the first finger bar units 64 are respectively misaligned with the second auxiliary bars 652 of the second finger bar units 65 in the second direction 52, and the first auxiliary bars 642 and the second auxiliary bars 652 are disposed in a staggered manner, such that imaginary lines, which extend in the second direction 52 and which pass through centers of the first auxiliary bars 642, respectively, do not pass through centers of the second auxiliary bars 652.

Every two adjacent ones of the first finger bars 641 of the first finger bar units 64 are spaced apart from each other in the first direction 51 by a distance d1, and every two adjacent ones of the second finger bars 651 are spaced apart from each other in the first direction 51 by the distance d1. The second ends 644 of the first finger bars 641 are aligned with one another along a first line L1. The second ends 654 of the second finger bars 651 of the second finger bar units 65 are aligned with one another along a second line L2 that is parallel to the first line L1. The first and second lines L1, L2 are spaced apart from each other by a distance d2, wherein d1 ≧ d2 > 100 µm.

The quality of each solar cell 3 can be inspected through electroluminescence inspection, which is conducted by applying a bias voltage to the solar cell 3 under test, followed by observing the uniformity of the brightness of the solar cell 3. When a non-uniform brightness is observed, the area of the solar cell 3, which has a higher brightness, has a higher current passing therethrough, and the area of the solar cell 3, which has a lower brightness, has a lower current passing therethrough. Normally, the area between the first and second lines L1, L2 has a lower brightness due to a lower current collecting ability. As such, the area may exhibit a slightly darker color as compared to the remaining area of the solar cell 3. The presence of the slightly dark area on the solar cell 3 is not a defect of the solar cell 3. However, the slightly darker area may adversely affect the appearance of the solar cell 3 in the electroluminescence inspection test. Hence, the smaller the distance d2 between the first and second lines L1, L2, the better the appearance of the solar cell 3 will be. On the other hand, when the distance d2 is too small, for instance, less than 100µm, the first and second auxiliary bars 642, 652 become too close to each other, and may cooperatively form a slim gray line or a dark line on the solar cell 3, which has an adverse effect on the appearance of the solar cell 3. In a similar manner, the distance d1 is preferably greater than 100µm so that the slim gray line or dark line in the electroluminescence inspection test will be less distinguishable.

Each of the first interconnecting bars 71 interconnects two adjacent ones of the first finger bar units 64, and is spaced apart from the first bus bar 61 in the second direction 52 by a distance less than the distance between each of the first auxiliary bars 642 and the first bus bar 61 in the second direction 52. Each of the second interconnecting bars 72 interconnects two adjacent ones of the second finger bar units 65, and is spaced apart from the second bus bar 62 in the second direction 52 by a distance less than the distance between each of the second auxiliary bars 652 and the second bus bar 62 in the second direction 52. In addition to being connected through the first auxiliary bars 642, the connections among the first finger bus units 64 are further enhanced through the first interconnecting bars 71. Similarly, in addition to being connected through the second auxiliary bars 652, the connections among the second finger bus units 65 are further enhanced through the second interconnecting bars 72. Hence, with the inclusion of the first and second interconnecting bars 71, 72 in the solar cell 3, the current collecting efficiency can be further enhanced.

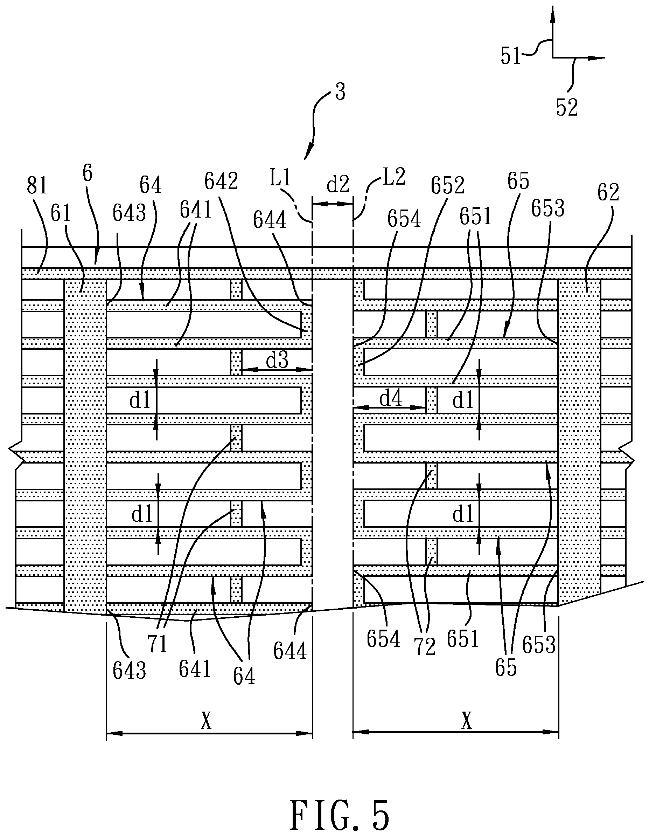

Each of the first and second finger bars 641, 651 has a length X in the second direction 52. Each of the first interconnecting bars 71 has two opposite ends that are disposed between and that are connected to two adjacent ones of the first finger bars 641, and is preferably spaced apart from the second end 644 of each of the two adjacent ones of the first finger bars 641 in the second direction 52 by a distance d3 (in this preferred embodiment, d3 is equal to the distance from the first interconnecting bar 71 to the first line L1 (see Fig. 5)), wherein X/2 ≧ d3 ≧ X/3. Each of the second interconnecting bars 72 has two opposite ends that are disposed between and that are connected to two adjacent ones of the second finger bars 651, and is preferably spaced apart from the second end 654 of each of the two adjacent ones of the second finger bars 651 in the second direction 52 by a distance d4 (in this preferred embodiment, d4 is equal to the distance from the second interconnecting bar 72 to the second line L2(see Fig. 5)), wherein X/2 ≧ d4 ≧ X/3. The preferred ranges of the distances d3 and d4 may result in a better appearance of the solar cell 3 under electroluminescence test.

The third finger bar units 66 are connected to one side of the second bus bar 62 that is opposite to the second finger bar units 65, and have the same structure as that of the second finger bar units 65. The third finger bar units 66 and the second finger bar units 65 are mirror symmetrical with respect to the second bus bar 62. Each of the third finger bar units 66 has a plurality of third finger bars 661 and a third auxiliary bar 662 that interconnects adjacent ends of the third finger bars 661. Each of the third interconnecting bars 73 interconnects two adjacent ones of the third finger bar units 66.

The fourth finger bar units 67 are connected to the third bus bar 63, extend in the second direction 52 toward and are spaced apart from the third finger bar units 66, and have the same structure as that of the first finger bar units 64. The fourth finger bar units 67 and the first finger bar units 64 are mirror symmetrical with respect to the second bus bar 62. Each of the fourth finger bar units 67 has a plurality of fourth finger bars 671 and a fourth auxiliary bar 672 that interconnects adjacent ends of the fourth finger bars 671. Each of the fourth interconnecting bars 74 interconnects two adjacent ones of the fourth finger bar units 67.

Each of the fifth finger bar units 68 includes a plurality of fifth finger bars 681 and a fifth auxiliary bar 682 that interconnects adjacent ends of the fifth finger bars 681. Each of the fifth interconnecting bars 75 interconnects two adjacent ones of the fifth finger bar units 68. The sixth finger bar units 69 and the fifth finger bar units 68 are mirror symmetrical with respect to the second bus bar 62. Each of the sixth finger bar units 69 includes a plurality of sixth finger bars 691 and a sixth auxiliary bar 692 that interconnects adjacent ends of the sixth finger bars 691. Each of the sixth interconnecting bars 76 interconnects two adjacent ones of the sixth finger bar units 69.

In this embodiment, the front electrode layer 6 further includes four extension bar units 80 that are disposed at four corners of each solar cell 3, and first and second connecting side bars 81, 82 that are parallel to and that are spaced apart from each other in the first direction 51 and that extend in the second direction 52. Two of the extension bar units 80 are connected to the first bus bar 61, while the remaining two of the extension bar units 80 are connected to the third bus bar 63. The first connecting side bar 81 interconnects first ends 611, 621, 631 of the first, second and third bus bars 61, 62, 63, while the second connecting side bar 82 interconnects second ends 612, 622, 632 of the first, second and third bus bars 61, 62, 63 that are opposite to the first ends of the first, second and third bus bars 61, 62, 63, respectively.

By designing the front electrode layer 6 to have a configuration where the second ends 644 of the first finger bar units 64 are spaced apart from the second ends 654 of the second finger bar units 65 in the second direction 52 by a spacing, which is different from the configuration of the front electrode layer 92 of the aforesaid conventional solar cell, the aforesaid problems, such as breaking of the finger bars and generation of undesired gray area and non-uniform brightness, associated with the conventional solar cell may be alleviated. In addition, with the inclusion of the first, second, third and fourth auxiliary bars 642, 652, 662, 672 and the first, second, third and fourth interconnecting bars 71, 72, 73, 74 in the front electrode layer 6 of the solar cell 3, a fine and continuous conductive network of the first, second, third and fourth finger bar units 64, 65, 66, 67 may be established, thereby enhancing the current collection efficiency and the photo-electro conversion efficiency of the solar cell 3.

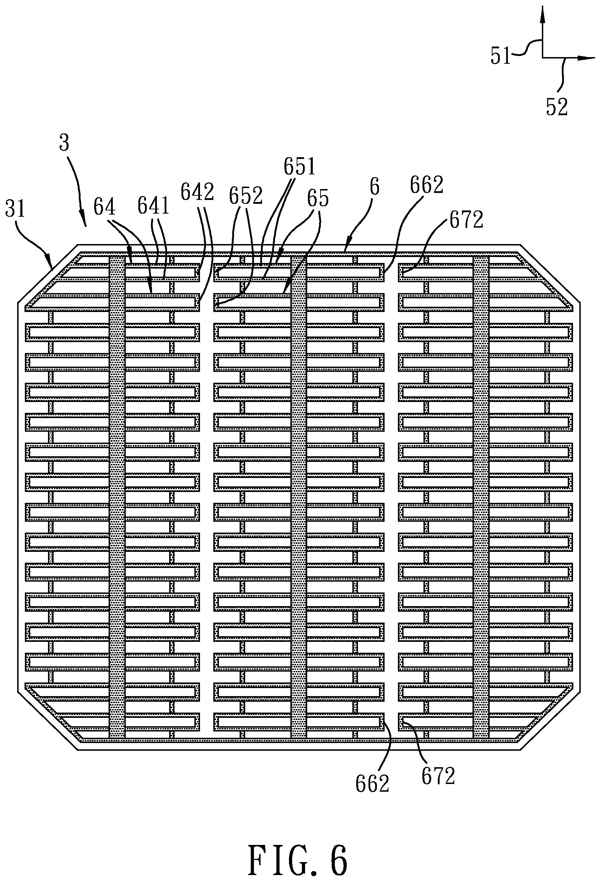

Fig. 6 illustrates the second preferred embodiment of the solar cell module according to the present invention. The second preferred embodiment differs from the previous embodiment in that the first auxiliarybars 642 are opposite to the second auxiliary bars 652, respectively, and that each of the first auxiliary bars 642 is aligned with the opposite one of the second auxiliary bars 652 along a line that extends in the second direction 52. In addition, the first finger bar units 64 are opposite to the second finger bar units 65, respectively, and the first finger bars 641 of each of the first finger bar units 64 are aligned with the second finger bars 651 of the opposite one of the second finger bar units 65 along lines that extend in the second direction 52, respectively. In a similar manner, the third auxiliary bars 662 and the fourth auxiliary bars 672 are opposite to each other in the second direction 52, respectively.

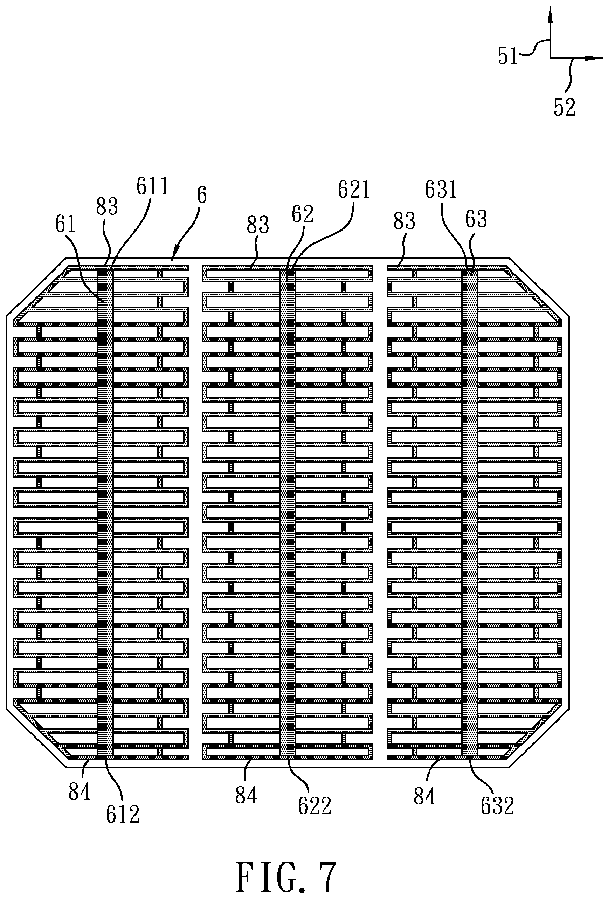

Fig. 7 illustrates the third preferred embodiment of the solar cell module according to the present invention. The third embodiment differs from the first preferred embodiment in that, instead of including the first and second connecting side bars 81, 82 in the previous embodiment, the front electrode layer 6 of this embodiment further includes three first connecting side bars 83 and three second connecting side bars 84. The first connecting side bars 83 extend in the second direction 52, and are spaced apart from and are aligned with each other in the second direction 52. The second connecting side bars 84 are spaced apart from and are aligned with each other in the second direction 52, respectively. The second connecting side bars 84 are parallel to and are spaced apart from and are respectively aligned with the first connecting side bars 83 in the first direction 52. The first connecting side bars 83 are connected to the first ends 611, 621, 631 of the first, second and third bus bars 61, 62, 63, respectively. The second connecting side bars 84 are connected to the second ends 612, 622, 632 of the first, second and third bus bars 61, 62, 63, respectively. The second preferred embodiment may also be modified to have a configuration including the first and second connecting side bars 83, 84.

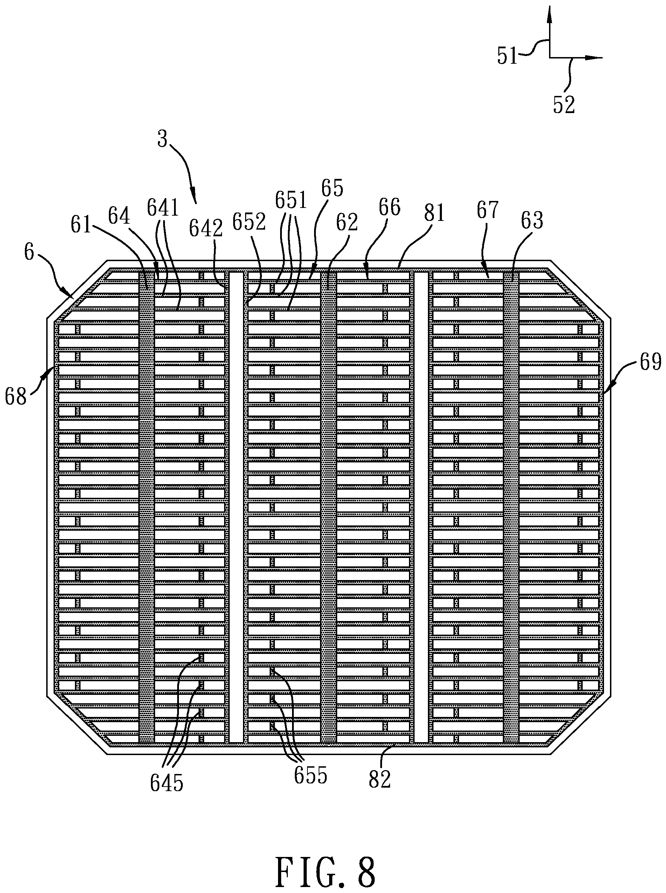

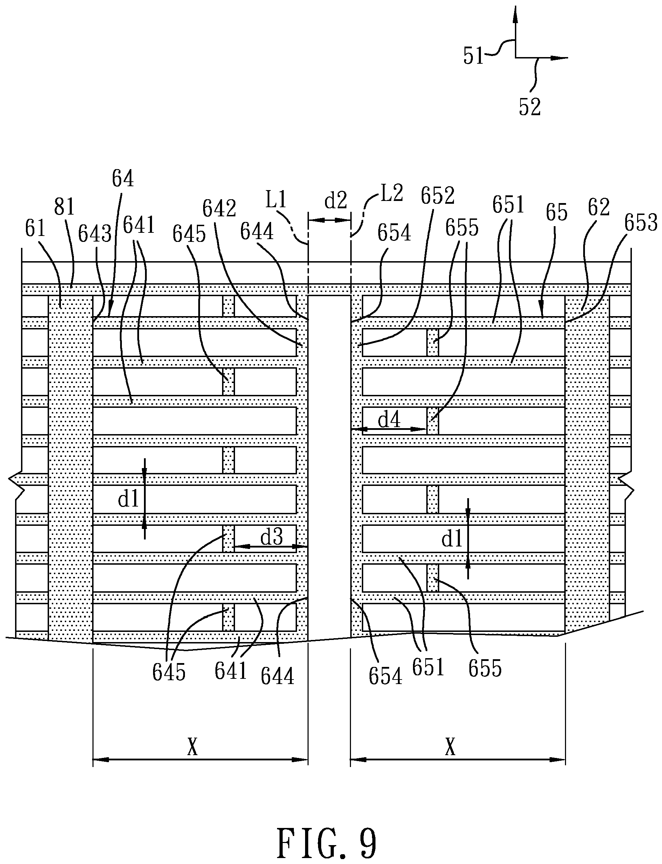

Figs. 8 and 9 illustrate the fourth preferred embodiment of the solar cell module according to the present invention. The fourth embodiment differs from the first preferred embodiment in the structure of the front electrode layer 6.

In this embodiment, the front electrode layer 6 includes a first bus bar 61, a second bus bar 62, a third bus bar 63, at least one first finger bar unit 64, at least one second finger bar unit 65, at least one third finger bar unit 66, at least one fourth finger bar unit 67, at least one fifth finger bar unit 68, at least one sixth finger bar unit 69, a plurality of first inner interconnecting bars 645, and a plurality of second inner interconnecting bars 655.

The first, second and third bus bars 61, 62, 63 extend in the first direction 51, and are aligned with and are spaced from each other in the second direction 52 that is transverse to the first direction 51.

The first finger bar unit 64 has a plurality of first finger bars 641 and a first auxiliary bar 642. The first finger bars 641 are connected to the first bus bar 61, and extend therefrom toward the second bus bar 62. Each of the first finger bars 641 has a first end 643 that is connected to the first bus bar 61, and a second end 644 that is opposite to the first end 643. The first auxiliary bar 642 interconnects the second ends 644 of all the first finger bars 641. Every two adjacent ones of the first finger bars 641 cooperatively form a pair of the first finger bars 641. Each of the first inner interconnecting bars 645 interconnects one of two adjacent pairs of the first finger bars 641, such that every other pair of the first finger bars 641 are interconnected by the respective one of the first inner interconnecting bars 645. Each of the first inner interconnecting bars 645 is spaced apart from the first bus bar 61 in the second direction 52 by a distance less than the distance between the first auxiliary bar 642 and the first bus bar 61 in the second direction 52.

The second finger bar unit 65 has a plurality of second finger bars 651 and a second auxiliary bar 652. The second finger bars 651 are connected to the second bus bar 652, and extend therefrom toward the first bus bar 61. Each of the second finger bars 651 has a first end 653 that is connected to the second bus bar 62, and a second end 654 that is opposite to the first end 653 of the second finger bar 651. The second auxiliary bar 652 interconnects the second ends 654 of all the second finger bars 651. Every two adjacent ones of the second finger bars 651 cooperatively form a pair of the second finger bars 651. Each of the second inner interconnecting bars 655 interconnects one of two adj acent pairs of the second finger bars 651, such that every other pair of the second finger bars 651 are interconnected by the respective one of the second inner interconnecting bars 655. Each of the second inner interconnecting bars 655 is spaced apart from the second bus bar 62 in the second direction 52 by a distance less than the distance between the second auxiliary bar 652 and the second bus bar 62 in the second direction 52.

The first and second finger bar units 64, 65 are disposed between the first and second bus bars 61, 62, and are spaced apart from each other by a spacing in the second direction 52. The first inner interconnecting bars 645 and the second inner interconnecting bars 655 are misaligned from each other in the second direction 52, respectively, and are disposed in a staggered manner, such that imaginary lines, which extend in the second direction 52 and which pass through centers of the first inner interconnecting bars 645, respectively, do not pass through centers of the second inner interconnecting bars 655.

Similar to the first preferred embodiment, the first and second lines L1, L2 of this embodiment are spaced apart from each other by the distance d2, wherein d1 ≧ d2 > 100µm.

Each of the first and second finger bars 641, 651 has a length X in the second direction 52. Each of the first inner interconnecting bars 645 has two opposite ends that are disposed between and that are connected to two adjacent ones of the first finger bars 641, and is preferably spaced apart from the second end 644 of each of the two adjacent ones of the first finger bars 641 in the second direction 52 by a distance d3 (in this preferred embodiment, d3 is equal to the distance from the first inner interconnecting bar 645 to the first line L1 (see Fig. 9)), wherein X/2 ≧ d3 ≧ X/3. Each of the second inner interconnecting bars 655 has two opposite ends that are disposed between and that are connected to two adjacent ones of the second finger bars 651, and is preferably spaced apart from the second end 654 of each of the two adjacent ones of the second finger bars 651 in the second direction 52 by a distance d4 (in this preferred embodiment, d4 is equal to the distance from the second inner interconnecting bar 655 to the second line L2 (see Fig. 9)), wherein X/2 ≧ d4 ≧ X/3. The preferred ranges of the distances d3 and d4 may result in a better appearance of the solar cell 3 under electroluminescence test.

The third finger bar units 66 and the second finger bar units 65 are mirror symmetrical with respect to the second bus bar 62. The fourth finger bar units 67 and the first finger bar units 64 are mirror symmetrical with respect to the second bus bar 62. The sixth finger bar units 69 and the fifth finger bar units 68 are mirror symmetrical with respect to the second bus bar 62. Each of the third, fourth, fifth and sixth finger bar units 66, 67, 68, 69 includes a plurality of finger bars and an auxiliary bar that is connected to adjacent ends of the finger bars.

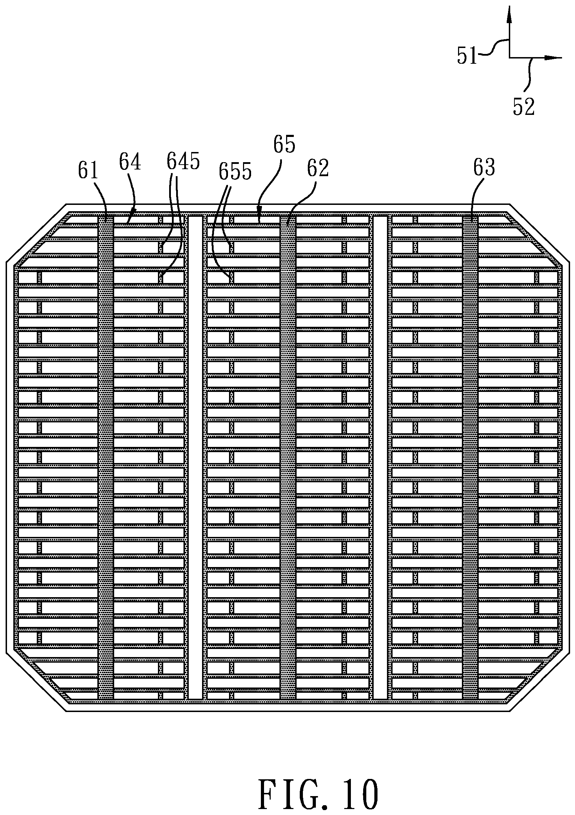

Fig. 10 illustrates the fifth preferred embodiment of the solar cell module according to the present invention. The fifth embodiment differs from the fourth preferred embodiment in that the first finger bar unit 64 and the second finger bar unit 65 are mirror symmetrical to each other and that the first inner interconnecting bars 645 are aligned with the second inner interconnecting bars 655 along lines that extend in the second direction 52, respectively.

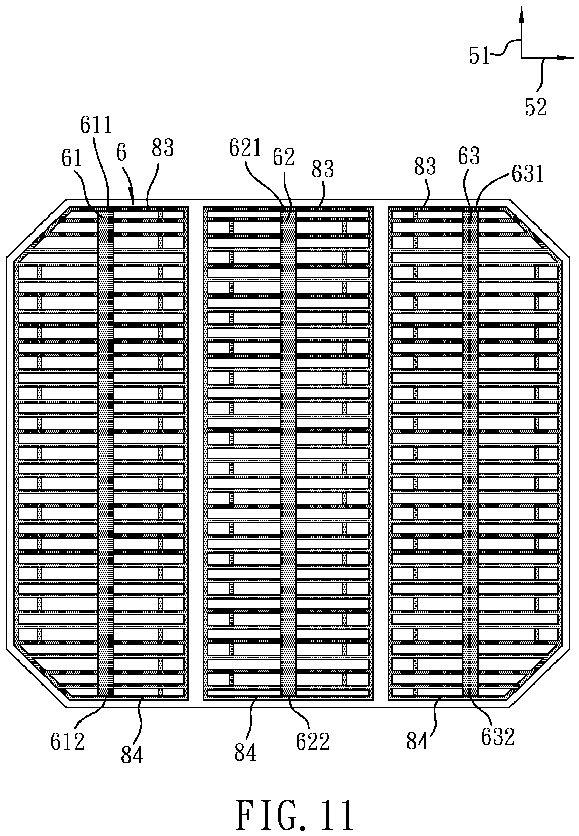

Fig. 11 illustrates the sixth preferred embodiment of the solar cell module according to the present invention. The sixth embodiment differs from the fourth preferred embodiment in that, instead of including the first and second connecting side bars 81, 82 in the fourth preferred embodiment, the front electrode layer 6 of this embodiment further includes three first connecting side bars 83 and three second connecting side bars 84. The first connecting side bars 83 extend in the second direction 52, and are spaced apart from and are aligned with each other in the second direction 52. The second connecting side bars 84 are spaced apart from and are aligned with each other in the second direction 52, respectively. The second connecting side bars 84 are parallel to and are spaced apart from and are respectively aligned with the first connecting side bars 83 in the first direction 52. The first connecting side bars 83 are connected to the first ends 611, 621, 631 of the first, second and third bus bars 61, 62, 63, respectively. The second connecting side bars 84 are connected to the second ends 612, 622, 632 of the first, second and third bus bars 61, 62, 63, respectively. The fifth preferred embodiment may also be modified to have a configuration including the first and second connecting side bars 83, 84.

## Claims

1. A solar cell (3) comprising:
a semiconductor substrate (31) having a light-receiving surface (311) and a back surface (312) opposite to said light-receiving surface (311);
a back electrode layer (32) disposed on said back surface (312); and
a front electrode layer (6) disposed on said light-receiving surface (311) and including a first bus bar (61), a second bus bar (62), a plurality of first finger bar units (64), a plurality of second finger bar units (65), a plurality of first interconnecting bars (71), and a plurality of second interconnecting bars (72), said first and second bus bars (61, 62) extending in a first direction (51) and being aligned with and being spaced apart from each other in a second direction (52) that is transverse to the first direction (51), said first and second finger bar units (64, 65) being disposed between said first and second bus bars (61, 62), said first finger bar units (64) being aligned with one another in the first direction (51), said second finger bar units (65) being aligned with one another in the first direction (51), said first finger bar units (64) being spaced apart from said second finger bar units (65);
wherein each of said first finger bar units (64) has a plurality of first finger bars (641) and a first auxiliary bar (642), said first finger bars (641) being connected to said first bus bar (61) and extending therefrom toward said second bus bar (62), each of said first finger bars (641) having a first end (643) that is connected to said first bus bar (61), and a second end (644) that is opposite to said first end (643), said first auxiliary bar (642) interconnecting said second ends (644) of said first finger bars (641), each of said second finger bar units (65) having a plurality of second finger bars (651) and a second auxiliary bar (652), said second finger bars (651) being connected to said second bus bar (62) and extending therefrom toward said first bus bar (61), each of said second finger bars (651) having a first end (653) that is connected to said second bus bar (62), and a second end (654) that is opposite to said first end (653) of said second finger bar (651), said second auxiliary bar (652) interconnecting said second ends (654) of said second finger bars (651);
wherein each of said first interconnecting bars (71) interconnects two adjacent ones of said first finger bar units (64) and is spaced apart from said first bus bar (61) in the second direction (52) by a distance less than the distance between each of said first auxiliary bars (642) and said first bus bar (61) in the second direction (52); and
wherein each of said second interconnecting bars (72) interconnects two adjacent ones of said second finger bar units (651) and is spaced apart from said second bus bar (62) in the second direction (52) by a distance less than the distance between each of said second auxiliary bars (652) and said second bus bar (62) in the second direction (52).

2. The solar cell (3) of claim 1, wherein every two adj a cent ones of said first finger bars (641) of said first finger bar units (64) are spaced apart from each other in the first direction (51) by a distance (d1), and every two adj acent ones of said second finger bars (651) are spaced apart from each other in the first direction (51) by the distance (d1), said second ends (644) of said first finger bars (641) being aligned with one another along a first line (L1), said second ends (654) of said second finger bars (651) of said second finger bar units (65) being aligned with one another along a second line (L2) that is parallel to said first line (L1), said first and second lines (L1, L2) being spaced apart from each other by a distance (d2), wherein d1 ≧ d2 > 100µm.

3. The solar cell (3) of claim 1, wherein said first auxiliary bars (642) of said first finger bar units (64) are respectively aligned with said second auxiliary bars (652) of said second finger bar units (65) in the second direction (52).

4. The solar cell (3) of claim 1, wherein said first auxiliary bars (641) of said first finger bar units (64) are respectively misaligned with said second auxiliary bars (652) of said second finger bar units (65) in the second direction (52).

5. The solar cell (3) as claimed in any one of claims 1 to 4, wherein each of said first and second finger bars (641, 651) has a length X in the second direction (52), each of said first interconnecting bars (71) having two opposite ends that are disposed between and that are connected to two adjacent ones of said first finger bars (641), and being spaced apart from said second end (644) of each of the two adjacent ones of said first finger bars (641) in the second direction (52) by a distance (d3), wherein X/2 ≧ d3 ≧ X/3, each of said second interconnecting bars (72) having two opposite ends that are disposed between and that are connected to two adjacent ones of said second finger bars (651), and being spaced apart from said second end (654) of each of said two adjacent ones of said second finger bars (651) in the second direction (52) by a distance (d4), wherein X/2 ≧ d4 ≧ X/3.

6. The solar cell (3) of claim 1, wherein each of said first and second bus bars (61, 62) has opposite first and second ends (611, 612, 621, 622), said front electrode layer (6) further including a first connecting side bar (81) that extends in the second direction (52) and that interconnects said first ends (611, 621) of said first and second bus bars (61, 62), and a second connecting side bar (82) that is spaced apart from and that is parallel to said first connecting side bar (81) and that interconnects said second ends (612, 622) of said first and second bus bars (61, 62).

7. The solar cell (3) of claim 1, wherein each of said first and second bus bars (61, 62) has opposite first and second ends (611, 612, 621, 622), said front electrode layer (6) further including two first connecting side bars (83) that extend in the second direction (52) and that are spaced apart from and that are aligned with each other in the second direction (52), and two second connecting side bars (84) that are spaced apart from and that are aligned with each other in the second direction (52), said second connecting side bars (84) being parallel to and being spaced apart from said first connecting side bars (83), said first connecting side bars (83) being connected to said first ends (611, 621) of said first and second bus bars (61, 62), respectively, said second connecting side bars (84) being connected to said second ends (612, 622) of said first and second bus bars (61, 62), respectively.

8. A solar cell module comprising:
opposite first and second panels (1, 2) that are spaced apart from each other;
at least one solar cell (3) as defined in any one of claims 1 to 7, said solar cell (3) being disposed between said first and second panels (1, 2); and
an enclosure (4) disposed between said first and second panels (1, 2) and enclosing said solar cell (3).

9. A solar cell (3) comprising:
a semiconductor substrate (31) having a light-receiving surface (311) and a back surface (312) opposite to said light-receiving surface (311);
a back electrode layer (32) disposed on said back surface (312); and
a front electrode layer (6) disposed on said light-receiving surface (311) and including a first bus bar (61), a second bus bar (62), at least one first finger bar unit (64), at least one second finger bar unit (65), at least one first inner interconnecting bar (645), and at least one second inner interconnecting bar (655), said first and second bus bars (61, 62) extending in a first direction (51) and being aligned with and being spaced from each other in a second direction (52) that is transverse to the first direction (51), said first and second finger bar units (64, 65) being disposed between said first and second bus bars (61, 62) and being spaced apart from each other;
wherein said first finger bar unit (64) has a plurality of first finger bars (641) and a first auxiliary bar (642), said first finger bars (641) being connected to said first bus bar (61) and extending therefrom toward said second bus bar (62), each of said first finger bars (641) having a first end (643) that is connected to said first bus bar (61), and a second end (644) that is opposite to said first end (643), said first auxiliary bar (642) interconnecting said second ends (644) of said first finger bars (641), said second finger bar unit (65) having a plurality of second finger bars (651) and a second auxiliary bar (652), said second finger bars (651) being connected to said second bus bar (62) and extending therefrom toward said first bus bar (61), each of said second finger bars (651) having a first end (653) that is connected to said second bus bar (62), and a second end (654) that is opposite to said first end (653) of said second finger bar (651), said second auxiliary bar (652) interconnecting said second ends (654) of said second finger bars (651);
wherein said first inner interconnecting bar (645) interconnects two adjacent ones of said first finger bars (641) and is spaced apart from said first bus bar (61) in the second direction (52) by a distance less than the distance between said first auxiliary bar (642) and said first bus bar (61) in the second direction (52) ; and
wherein said second inner interconnecting bar (655) interconnects two adjacent ones of said second finger bars (651) and is spaced apart from said second bus bar (62) in the second direction (52) by a distance less than the distance between said second auxiliary bar (652) and said second bus bar (62) in the second direction (52).

10. The solar cell (3) of claim 9, wherein every two adjacent ones of said first finger bars (641) are spaced apart from each other in the first direction (51) by a distance (d1), and every two adjacent ones of said second finger bars (651) are spaced apart from each other in the first direction (51) by the distance (d1), said second ends (644) of said first finger bars (641) being aligned with one another along a first line (L1), said second ends (654) of said second finger bars (651) being aligned with one another along a second line (L2) that is parallel to said first line (L1), said first and second lines (L1, L2) being spaced apart from each other by a distance (d2), wherein d1 ≧ d2 > 100µm.

11. The solar cell (3) of claim 9, wherein said first inner interconnecting bar (645) and said second inner interconnecting bar (655) are aligned with each other in the second direction (52).

12. The solar cell of claim 9, wherein said first inner interconnecting bar (645) and said second inner interconnecting bar (655) are misaligned with each other in the second direction (52).

13. The solar cell (3) as claimed in any one of claims 9 to 12, wherein each of said first and second finger bars (641, 651) has a length X in the second direction (52), said first inner interconnecting bar (645) having two opposite ends that are disposed between and that are connected to two adjacent ones of said first finger bars (641), and being spaced apart from said second end (644) of each of said two adjacent ones of said first finger bars (641) in the second direction (52) by a distance (d3), wherein X/2 ≧ d3 ≧ X/3, said second interconnecting bar (655) having two opposite ends that are disposed between and that are connected to two adjacent ones of said second finger bars (651), and being spaced apart from said second end (654) of each of said two adjacent ones of said second finger bars (651) in the second direction (52) by a distance (d4), wherein X/2 ≧ d4 ≧ X/3.

14. The solar cell (3) of claim 9, wherein each of said first and second bus bars (61, 62) has opposite first and second ends (611, 612, 621, 622), said front electrode layer (6) further including a first connecting side bar (81) that extends in the second direction (52) and that interconnects said first ends (611, 621) of said first and second bus bars (61, 62), and a second connecting side bar (82) that is spaced apart from and that is parallel to said first connecting side bar (81) and that interconnects said second ends (612, 622) of said first and second bus bars (61, 62).

15. The solar cell (3) of claim 9, wherein each of said first and second bus bars (61, 62) has opposite first and second ends (611, 612, 621, 622), said front electrode layer (6) further including two first connecting side bars (83) that extend in the second direction (52) and that are spaced apart from and that are aligned with each other in the second direction (52), and two second connecting side bars (84) that are spaced apart from and that are aligned with each other in the second direction (52), said second connecting side bars (84) being parallel to and being spaced apart from said first connecting side bars (83), said first connecting side bars (83) being connected to said first ends (611, 621) of said first and second bus bars (61, 62), respectively, said second connecting side bars (84) being connected to said second ends (612, 622) of said first and second bus bars (61, 62), respectively.

16. A solar cell module comprising:
opposite first and second panels (1, 2) that are spaced apart from each other;
at least one solar cell (3) as defined in any one of claims 9 to 15, said solar cell (3) being disposed between said first and second panels (1, 2); and
an enclosure (4) disposed between said first and second panels (1, 2) and enclosing said solar cell (3).

## Patentansprüche

1. Solarzelle (3), umfassend:
ein Halbleitersubstrat (31), das eine lichtempfangende Oberfläche (311) und eine der lichtempfangenden Oberfläche (311) gegenüberliegende Rückseitertoberfläche (312) aufweist,
eine Rückseitenelektrodenschicht (32), die an der Rückseitenoberfläche (312) angeordnet ist, und
eine Vorderseitenelektrodenschicht (6), die an der lichtempfangenden Oberfläche (311) angeordnet ist und eine erste Sammelschiene (61), eine zweite Sammelschiene (62), eine Mehrzahl von ersten Fingerstreifeneinheiten (64), eine Mehrzahl von zweiten Fingerstreifeneinheiten (65), eine Mehrzahl von ersten Verbindungsstreifen (71) und eine Mehrzahl von zweiten Verbindungsstreifen (72) beinhaltet, wobei sich die erste und die zweite Sammelschiene (61, 62) in einer ersten Richtung (51) erstecken und in einer zweiten Richtung (52), die zu der ersten Richtung (51) transversal ist, einander entsprechend ausgerichtet sind und voneinander beabstandet sind, wobei die ersten und die zweiten Fingerstreifeneinheiten (64, 65) zwischen der ersten und der zweiten Sammelschiene (61, 62) angeordnet sind, wobei die ersten Fingerstreifeneinheiten (64) in der ersten Richtung (51) einander entsprechend ausgerichtet sind, wobei die zweiten Fingerstreifeneinheiten (65) in der ersten Richtung (51) einander entsprechend ausgerichtet sind, wobei die ersten Fingerstreifeneinheiten (64) von den zweiten Fingerstreifeneinheiten (65) beabstandet sind,
wobei jede der ersten Fingerstreifeneinheiten (64) eine Mehrzahl von ersten Fingerstreifen (641) und einen ersten Hilfsstreifen (642) aufweist, wobei die ersten Fingerstreifen (641) mit der ersten Sammelschiene (61) verbunden sind und sich von dieser in Richtung der zweiten Sammelschiene (62) erstrecken, wobei jeder der ersten Fingerstreifen (641) ein erstes Ende (643), das mit der ersten Sammelschiene (61) verbunden ist, und ein zweites Ende (644) hat, das dem ersten Ende (643) gegenüberliegt, wobei der erste Hilfsstreifen (642) die zweiten Enden (644) der ersten Fingerstreifen (641) miteinander verbindet, wobei jede der zweiten Fingerstreifeneinheiten (65) eine Mehrzahl von zweiten Fingerstreifen (651) und einen zweiten Hilfsstreifen (652) aufweist, wobei die zweiten Fingerstreifen (651) mit der zweiten Sammelschiene (62) verbunden sind und sich von dieser in Richtung der ersten Sammelschiene (61) erstrecken, wobei jeder der zweiten Fingerstreifen (651) ein erstes Ende (653), das mit der zweiten Sammelschiene (62) verbunden ist, und ein zweites Ende (654) hat, das dem ersten Ende (653) des zweiten Fingerstreifens (651) gegenüberliegt, wobei der zweite Hilfsstreifen (652) die zweiten Enden (654) der zweiten Fingerstreifen (651) miteinander verbindet,
wobei jeder der ersten Verbindungsstreifen (71) zwei benachbarte der ersten Fingerstreifeneinheiten (64) miteinander verbindet und in der zweiten Richtung (52) durch einen Abstand von der ersten Sammelschiene (61) beabstandet ist, der geringer ist als der Abstand zwischen jedem der ersten Hilfsstreifen (642) und der ersten Sammelschiene (61) in der zweiten Richtung (52), und
wobei jeder der zweiten Verbindungsstreifen (72) zwei benachbarte der zweiten Fingerstreifeneinheiten (651) miteinander verbindet und in der zweiten Richtung (52) durch einen Abstand von der zweiten Sammelschiene (62) beabstandet ist, der geringer ist als der Abstand zwischen jedem der zweiten Hilfsstreifen (652) und der zweiten Sammelschiene (62) in der zweiten Richtung (52).

2. Solarzelle (3) nach Anspruch 1, bei welcher jeweils zwei zueinander benachbarte der ersten Fingerstreifen (641) der ersten Fingerstreifeneinheiten (64) in der ersten Richtung (51) durch einen Abstand (d1) voneinander getrennt sind, wobei jeweils zwei zueinander benachbarte der zweiten Fingerstreifen (651) in der ersten Richtung (51) durch den Abstand (d1) voneinander getrennt sind, wobei die zweiten Enden (644) der ersten Fingerstreifen (641) entlang einer ersten Linie (L1) einander entsprechend ausgerichtet sind, wobei die zweiten Enden (654) der zweiten Fingerstreifen (651) der zweiten Fingerstreifeneinheiten (65) entlang einer zweiten Linie (L2), welche zu der ersten Linie (L1) parallel ist, einander entsprechend ausgerichtet sind, wobei die erste und die zweite Linie (L1, L2) durch einen Abstand (d2) voneinander getrennt sind, wobei d1 ≧ d2 > 100µm ist.

3. Solarzelle (3) nach Anspruch 1, bei welcher die ersten Hilfsstreifen (642) der ersten Fingerstreifeneinheiten (64) jeweils den zweiten Hilfsstreifen (652) der zweiten Fingerstreifeneinheiten (65) entsprechend in der zweiten Richtung (52) ausgerichtet sind.

4. Solarzelle (3) nach Anspruch 1, bei welcher die ersten Hilfsstreifen (641) der ersten Fingerstreifeneinheiten (64) in der zweiten Richtung (52) jeweils nichtfluchtend zu den zweiten Hüfsstreifen (652) der zweiten Fingerstreifeneinheiten (65) ausgerichtet sind.

5. Solarzelle (3) nach einem der Ansprüche 1 bis 4, bei welcher jeder der ersten und der zweiten Fingerstreifen (641, 651) in der zweiten Richtung (52) eine Länge X hat, wobei jeder der ersten Verbindungsstreifen (71) zwei gegenüberliegende Enden hat, die zwischen zwei benachbarten der ersten Fingerstreifen (641) angeordnet und mit diesen verbunden sind und von dem zweiten Ende (644) von jedem der zwei benachbarten der ersten Fingerstreifen (641) in der zweiten Richtung (52) durch einen Abstand (d3) getrennt sind, wobei X/2 ≧ d3 ≧ X/3 ist, wobei jeder der zweiten Verbindungsstreifen (72) zwei gegenüberliegende Enden hat, die zwischen zwei benachbarten der zweiten Fingerstreifen (651) angeordnet sind und mit diesen verbunden sind und von dem zweiten Ende (654) von jedem der zwei benachbarten der zweiten Fingerstreifen (651) in der zweiten Richtung (52) durch einen Abstand (d4) getrennt sind, wobei X/2 ≧ d4 ≧ X/3 ist.

6. Solarzelle (3) nach Anspruch 1, bei welcher sowohl die erste als auch die zweite Sammelschiene (61, 62) ein erstes und ein zweites Ende (611, 612, 621, 622) aufweist, die einander gegenüberliegen, wobei die Vorderseitenelektrodenschicht (6) ferner einen ersten Verbindungsseitenstreifen (81), der sich in der zweiten Richtung (52) erstreckt und die ersten Enden (611, 621) der ersten und der zweiten Sammelschiene (61, 62) miteinander verbindet, und einen zweiten Verbindungsseitenstreifen (82) beinhaltet, der von dem ersten Verbindungsseitenstreifen (81) beabstandet ist und zu diesem parallel ist und welcher die zweiten Enden (612, 622) der ersten und der zweiten Sammelschiene (61, 62) miteinander verbindet.

7. Solarzelle (3) nach Anspruch 1, bei welcher sowohl die erste als auch die zweite Sammelschiene (61, 62) ein erstes und ein zweites Ende (611, 612, 621, 622) aufweist, die einander gegenüberliegen, wobei die Vorderseitenelektrodenschicht (6) ferner zwei erste Verbindungsseitenstreifen (83), welche sich in der zweiten Richtung (52) erstrecken und in der zweiten Richtung (52) voneinander beabstandet und einander entsprechend ausgerichtet sind, und zwei zweite Verbindungsseitenstreifen (84) beinhaltet, welche in der zweiten Richtung (52) voneinander beabstandet und einander entsprechend ausgerichtet sind, wobei die zweiten Verbindungsseitenstreifen (84) parallel zu den ersten Verbindungsseitenstreifen (83) und von diesen beabstandet sind, wobei die ersten Verbindungsseitenstreifen (83) entsprechend mit den ersten Enden (611, 621) der ersten und der zweiten Sammelschiene (61, 62) verbunden sind, wobei die zweiten Verbindungsseitenstreifen (84) entsprechend mit den zweiten Enden (612, 622) der ersten und der zweiten Sammelschiene (61, 62), verbunden sind.

8. Solarzellenmodul, umfassend:
eine erste und eine zweite Platte (1, 2), die einander gegenüberliegen und welche voneinander beabstandet sind,
wenigstens eine Solarzelle (3) gemäß der Definition nach einem der Ansprüche 1 bis 7, wobei die Solarzelle (3) zwischen der ersten und der zweiten Platte (1, 2) angeordnet ist, und
eine Ummantelung (4), die zwischen der ersten und der zweiten Platte (1, 2) angeordnet ist und die Solarzelle (3) umschließt.

9. Solarzelle (3), umfassend:
ein Halbleitersubstrat (31), das eine lichtempfangende Oberfläche (311) und eine der lichtempfangenden Oberfläche (311) gegenüberliegende Rückseitenoberfläche (312) aufweist,
eine Rückseitenelektrodenschicht (32), die an der Rückseitenoberfläche (312) angeordnet ist, und
eine Vorderseitenelektrodenschicht (6), die an der lichtempfangenden Oberfläche (311) angeordnet ist und eine erste Sammelschiene (61), eine zweite Sammelschiene (62), wenigstens eine erste Fingerstreifeneinheit (64), wenigstens eine zweite Fingerstreifeneinheit (65), wenigstens einen ersten inneren Verbindungsstreifen (645), und wenigstens einen zweiten inneren Verbindungsstreifen (655) beinhaltet, wobei sich die erste und die zweite Sammelschiene (61, 62) in einer ersten Richtung (51) erstrecken und in einer zweiten Richtung (52), die zu der ersten Richtung (51) transversal ist, einander entsprechend ausgerichtet sind und voneinander beabstandet sind, wobei die ersten und die zweiten Fingerstreifeneinheiten (64, 65) zwischen der ersten und der zweiten Sammelschiene (61, 62) angeordnet sind und voneinander beabstandet sind,
wobei die erste Fingerstreifeneinheit (64) eine Mehrzahl von ersten Fingerstreifen (641) und einen ersten Hilfsstreifen (642) aufweist, wobei die ersten Fingerstreifen (641) mit der ersten Sammelschiene (61) verbunden sind und sich von dieser in Richtung der zweiten Sammelschiene (62) erstrecken, wobei jeder der ersten Fingerstreifen (641) ein erstes Ende (643), das mit der ersten Sammelschiene (61) verbunden ist, und ein zweites Ende (644) hat, welches dem ersten Ende (643) gegenüberliegt, wobei der erste Hilfsstreifen (642) die zweiten Enden (644) der ersten Fingerstreifen (641) miteinander verbindet, wobei die zweite Fingerstreifeneinheit (65) eine Mehrzahl von zweiten Fingerstreifen (651) und einen zweiten Hilfsstreifen (652) aufweist, wobei die zweiten Fingerstreifen (651) mit der zweiten Sammelschiene (62) verbunden sind und sich von dieser in Richtung der ersten Sammelschiene (61) erstrecken, wobei jeder der zweiten Fingerstreifen (651) ein erstes Ende (653), das mit der zweiten Sammelschiene (62) verbunden ist, und ein zweites Ende (654) hat, welches dem ersten Ende (653) des zweiten Fingerstreifens (651) gegenüberliegt, wobei der zweite Hilfsstreifen (652) die zweiten Enden (654) der zweiten Fingerstreifen (651) miteinander verbindet,
wobei der erste innere Verbindungsstreifen (645) zwei benachbarte der ersten Fingerstreifen (641) miteinander verbindet und in der zweiten Richtung (52) durch einen Abstand von der ersten Sammelschiene (61) getrennt ist, der geringer ist als der Abstand zwischen dem ersten Hilfsstreifen (642) und der ersten Sammelschiene (61) in der zweiten Richtung (52), und
wobei der zweite innere Verbindungsstreifen (655) zwei benachbarte der zweiten Fingerstreifen (651) miteinander verbindet und in der zweiten Richtung (52) durch einen Abstand von der zweiten Sammelschiene (62) getrennt ist, der geringer ist als der Abstand zwischen dem zweiten Hilfsstreifen (652) und der zweiten Sammelschiene (62) in der zweiten Richtung (52).

10. Solarzelle (3) nach Anspruch 9, bei welcher jeweils zwei zueinander benachbarte der ersten Fingerstreifen (641) in der ersten Richtung (51) durch einen Abstand (d1) voneinander getrennt sind, wobei jeweils zwei zueinander benachbarte der zweiten Fingerstreifen (651) in der ersten Richtung (51) durch den Abstand (d1) voneinander getrennt sind, wobei die zweiten Enden (644) der ersten Fingerstreifen (641) entlang einer ersten Linie (L1) einander entsprechend ausgerichtet sind, wobei die zweiten Enden (654) der zweiten Fingerstreifen (651) entlang einer zweiten Linie (L2), welche zu der ersten Linie (L1) parallel ist, einander entsprechend ausgerichtet sind, wobei die erste und die zweite Linie (L1, L2) voneinander durch einen Abstand (d2) getrennt sind, wobei d1 ≧ d2 > 100µm ist.

11. Solarzelle (3) nach Anspruch 9, bei welcher der erste innere Verbindungsstreifen (645) und der zweite innere Verbindungsstreifen (655) in der zweiten Richtung (52) einander entsprechend ausgerichtet sind.

12. Solarzelle nach Anspruch 9, bei welcher der erste innere Verbindungsstreifen (645) und der zweite innere Verbindungsstreifen (655) in der zweiten Richtung (52) zueinander nichtfluchtend ausgerichtet sind.

13. Solarzelle (3) nach einem der Ansprüche 9 bis 12, bei welcher jeder der ersten und zweiten Fingerstreifen (641, 651) in der zweiten Richtung (52) eine Länge X hat, wobei der erste innere Verbindungsstreifen (645) zwei gegenüberliegende Ende hat, die zwischen zwei benachbarten der ersten Fingerstreifen (641) angeordnet sind und mit diesen verbunden sind und von dem zweiten Ende (644) von jedem dieser zwei benachbarten der ersten Fingerstreifen (641) in der zweiten Richtung (52) durch einen Abstand (d3) getrennt sind, wobei X/2 ≧ d3 ≧ X/3 ist, wobei der zweite Verbindungsstreifen (655) zwei gegenüberliegende Ende hat, die zwischen zwei benachbarten der zweiten Fingerstreifen (651) angeordnet sind und mit diesen verbunden sind und von dem zweiten Ende (654) von jedem dieser zwei benachbarten der zweiten Fingerstreifen (651) in der zweiten Richtung (52) durch einen Abstand (d4) getrennt sind, wobei X/2 ≧ d4 ≧ X/3 ist.

14. Solarzelle (3) nach Anspruch 9, bei welcher sowohl die erste als auch die zweite Sammelschiene (61, 62) ein erstes und ein zweites Ende (611, 612, 621, 622) aufweist, die einander gegenüberliegen, wobei die Vorderseitenelektrodenschicht (6) ferner einen ersten Verbindungsseitenstreifen (81), der sich in der zweiten Richtung (52) erstreckt und der die ersten Enden (611, 621) der ersten und der zweiten Sammelschiene (61, 62) miteinander verbindet, und einen zweiten Verbindungsseitenstreifen (82) beinhaltet, der von dem ersten Verbindungsseitenstreifen (81) beabstandet ist und parallel zu diesem ist und der die zweiten Enden (612, 622) der ersten und der zweiten Sammelschiene (61, 62) miteinander verbindet.

15. Solarzelle (3) nach Anspruch 9, bei welcher sowohl die erste als auch die zweite Sammelschiene (61, 62) ein erstes und ein zweites Ende (611, 612, 621, 622) aufweist, die einander gegenüberliegen, wobei die Vorderseitenelektrodenschicht (6) ferner zwei erste Verbindungsseitenstreifen (83), welche sich in der zweiten Richtung (52) erstrecken und welche in der zweiten Richtung (52) voneinander beabstandet und einander entsprechend ausgerichtet sind, und zwei zweite Verbindungsseitenstreifen (84) beinhaltet, welche in der zweiten Richtung (52) voneinander beabstandet und einander entsprechend ausgerichtet sind, wobei die zweiten Verbindungsseitenstreifen (84) parallel zu den ersten Verbindungsseitenstreifen (83) sind und von diesen beabstandet sind, wobei die ersten Verbindungsseitenstreifen (83) entsprechend mit den ersten Enden (611, 621) der ersten und der zweiten Sammelschiene (61, 62) verbunden sind, wobei die zweiten Verbindungsseitenstreifen (84) entsprechend mit den zweiten Enden (612, 622) der ersten und der zweiten Sammelschiene (61, 62) verbunden sind.

16. Solarzellenmodul, umfassend:
eine erste und eine zweite Platte (1, 2), die einander gegenüberliegen und welche voneinander beabstandet sind,
wenigstens eine Solarzelle (3) gemäß der Definition nach einem der Ansprüche 9 bis 15, wobei die Solarzelle (3) zwischen der ersten und der zweiten Platte (1, 2) angeordnet ist, und
eine Ummantelung (4), die zwischen der ersten und der zweiten Platte (1, 2) angeordnet ist und die Solarzelle (3) umschließt.

## Revendications

1. Cellule solaire (3) comprenant:
un substrat semi-conducteur (31) ayant une surface recevant la lumière (311) et une surface arrière (312) opposée à ladite surface recevant la lumière (311);
une couche d'électrode arrière (32) disposée sur ladite surface arrière (312); et
une couche d'électrode avant (6) disposée sur ladite surface recevant la lumière (311) et
comprenant une première barre omnibus (61), une seconde barre omnibus (62), une pluralité d'unités à premières barres supports (64), une pluralité d'unités à secondes barres supports (65), une pluralité de premières barres d'interconnexion (71), et une pluralité de secondes barres d'interconnexion (72), lesdites première et seconde barres omnibus (61, 62) s'étendant dans une première direction (51) et étant alignées l'une sur l'autre et étant espacées l'une de l'autre dans une seconde direction (52) qui est transversale par rapport à la première direction (51), lesdites unités à premières et
secondes barres supports (64, 65) étant disposées entre lesdites première et seconde barres omnibus (61, 62), lesdites unités à premières barres supports (64) étant alignées sur une autre dans la première direction (51), lesdites unités à secondes barres supports (65) étant alignées sur une autre dans la première direction (51), lesdites unités à premières barres supports (64) étant espacées desdites unités à secondes barres supports (65);
dans laquelle chacune desdites unités à premières barres supports (64) a une pluralité de premières barres supports (641) et une première barre auxiliaire (642), lesdites premières barres supports (641) étant connectées à ladite première barre omnibus (61) et s'étendant à partir de là vers ladite seconde barre omnibus (62), chacune desdites premières barres supports (641) ayant une première extrémité (643) qui est connectée à ladite première barre omnibus (61), et une seconde extrémité (644) qui est opposée à ladite première extrémité (643), ladite première barre auxiliaire (642) interconnectant lesdites secondes extrémités (644) desdites premières barres supports (641), chacune desdites unités à secondes barres supports (65) ayant une pluralité de secondes barres supports (651) et une seconde barre auxiliaire (652), lesdites secondes barres supports (651) étant connectées à ladite seconde barre omnibus (62) et s'étendant à partir de là vers ladite première barre omnibus (61), chacune desdites secondes barres supports (651) ayant une première extrémité (653) qui est connectée à ladite seconde barre omnibus (62), et une seconde extrémité (654) qui est opposée à ladite première extrémité (653) de ladite seconde barre support (651), ladite seconde barre auxiliaire (652) interconnectant lesdites secondes extrémités (654) desdites secondes barres supports (651);
dans laquelle chacune desdites premières barres d'interconnexion (71) interconnecte deux adjacentes desdites unités à premières barres supports (64) et est espacée de ladite première barre omnibus (61) dans la seconde direction (52) par une distance inférieure à la distance entre chacune desdites premières barres auxiliaires (642) et ladite première barre omnibus (61) dans la seconde direction (52); et
dans laquelle chacune desdites secondes barres d'interconnexion (72) interconnecte deux adjacentes desdites unités à secondes barres supports (651) et est espacée de ladite seconde barre omnibus (62) dans la seconde direction (52) par une distance inférieure à la distance entre chacune desdites secondes barres auxiliaires (652) et ladite seconde barre omnibus (62) dans la seconde direction (52).

2. Cellule solaire (3) de la revendication 1, dans laquelle toutes les deux adjacentes desdites premières barres supports (641) desdites unités à premières barres supports (64) sont espacées l'une de l'autre dans la première direction (51) par une distance (d1), et toutes les deux adjacentes desdites secondes barres supports (651) sont espacées l'une de l'autre dans la première direction (51) par la distance (d1), lesdites secondes extrémités (644) desdites premières barres supports (641) étant alignées sur une autre le long d'une première ligne (L1), lesdites secondes extrémités (654) desdites secondes barres supports (651) desdites unités à secondes barres supports (65) étant alignées sur une autre le long d'une seconde ligne (L2) qui est parallèle à ladite première ligne (L1), lesdites première et seconde lignes (L1, L2) étant espacées l'une de l'autre par une distance (d2), dans laquelle d1 ≥ d2 > 100 µm.

3. Cellule solaire (3) de la revendication 1, dans laquelle lesdites premières barres auxiliaires (642) desdites unités à premières barres supports (64) sont respectivement alignées sur lesdites secondes barres auxiliaires (652) desdites unités à secondes barres supports (65) dans la seconde direction (52).

4. Cellule solaire (3) de la revendication 1, dans laquelle lesdites premières barres auxiliaires (641) desdites unités à premières barres supports (64) sont respectivement désalignées par rapport auxdites secondes barres auxiliaires (652) desdites unités à secondes barres supports (65) dans la seconde direction (52).

5. Cellule solaire (3) selon l'une quelconque des revendications 1 à 4, dans laquelle chacune desdites premières et secondes barres supports (641, 651) a une longueur X dans la seconde direction (52), chacune desdites premières barres d'interconnexion (71) ayant deux extrémités opposées qui sont disposées entre et qui sont connectées à deux adjacentes desdites premières barres supports (641), et étant espacée de ladite seconde extrémité (644) de chacune des deux adjacentes desdites premières barres supports (641) dans la seconde direction (52) par une distance (d3), dans laquelle X/2 ≥ d3 ≥ X/3, chacune desdites secondes barres d'interconnexion (72) ayant deux extrémités opposées qui sont disposées entre et qui sont connectées à deux adjacentes desdites secondes barres supports (651), et étant espacée de ladite seconde extrémité (654) de chacune desdites deux adjacentes desdites secondes barres supports (651) dans la seconde direction (52) par une distance (d4), dans laquelle X/2≥d4≥X/3.

6. Cellule solaire (3) de la revendication 1, dans laquelle chacune desdites première et seconde barres omnibus (61, 62) a des première et seconde extrémités (611, 612, 621, 622) opposées, ladite couche d'électrode avant (6) comprenant en outre une première barre latérale de connexion (81) qui s'étend dans la seconde direction (52) et qui interconnecte lesdites premières extrémités (611, 621) desdites première et seconde barres omnibus (61, 62), et une seconde barre latérale de connexion (82) qui est espacée de et qui est parallèle à ladite première barre latérale de connexion (81) et qui interconnecte lesdites secondes extrémités (612, 622) desdites première et seconde barres omnibus (61, 62).

7. Cellule solaire (3) de la revendication 1, dans laquelle chacune desdites première et seconde barres omnibus (61, 62) a des première et seconde extrémités (611, 612, 621, 622) opposées, ladite couche d'électrode avant (6) comprenant en outre deux premières barres latérales de connexion (83) qui s'étendent dans la seconde direction (52) et qui sont espacées l'une de l'autre et qui sont alignées l'une sur l'autre dans la seconde direction (52), et deux secondes barres latérales de connexion (84) qui sont espacées l'une de l'autre et qui sont alignées l'une sur l'autre dans la seconde direction (52), lesdites secondes barres latérales de connexion (84) étant parallèles auxdites et étant espacées desdites premières barres latérales de connexion (83), lesdites premières barres latérales de connexion (83) étant connectées auxdites premières extrémités (611, 621) desdites première et seconde barres omnibus (61, 62), respectivement, lesdites secondes barres latérales de connexion (84) étant connectées auxdites secondes extrémités (612, 622) desdites première et seconde barres omnibus (61, 62), respectivement.

8. Module à cellule(s) solaire(s) comprenant:
des premier et second panneaux (1, 2) opposés qui sont espacés l'un de l'autre;
au moins une cellule solaire (3) telle que définie dans l'une quelconque des revendications 1 à 7, ladite cellule solaire (3) étant disposée entre lesdits premier et
second panneaux (1, 2); et
un boîtier (4) disposé entre lesdits premier et second panneaux (1, 2) et renfermant ladite cellule solaire (3).

9. Cellule solaire (3) comprenant:
un substrat semi-conducteur (31) ayant une surface recevant la lumière (311) et une surface arrière (312) opposée à ladite surface recevant la lumière (311);
une couche d'électrode arrière (32) disposée sur ladite surface arrière (312); et
une couche d'électrode avant (6) disposée sur ladite surface recevant la lumière (311) et
comprenant une première barre omnibus (61), une seconde barre omnibus (62), au moins une unité à premières barres supports (64), au moins une unité à secondes barres supports (65), au moins une première barre d'interconnexion intérieure (645), et au moins une seconde barre d'interconnexion intérieure (655), lesdites première et
seconde barres omnibus (61, 62) s'étendant dans une première direction (51) et étant alignées l'une sur l'autre et étant espacées l'une de l'autre dans une seconde direction (52) qui est transversale par rapport à la première direction (51), lesdites unités à premières et secondes barres supports (64, 65) étant disposées entre lesdites première et seconde barres omnibus (61, 62) et étant espacées l'une de l'autre;
dans laquelle ladite unité à premières barres supports (64) a une pluralité de premières barres supports (641) et une première barre auxiliaire (642), lesdites premières barres supports (641) étant connectées à ladite première barre omnibus (61) et s'étendant à partir de là vers ladite seconde barre omnibus (62), chacune desdites premières barres supports (641) ayant une première extrémité (643) qui est connectée à ladite première barre omnibus (61), et une seconde extrémité (644) qui est opposée à ladite première extrémité (643), ladite première barre auxiliaire (642) interconnectant lesdites secondes extrémités (644) desdites premières barres supports (641), ladite unité à secondes barres supports (65) ayant une pluralité de secondes barres supports (651) et une seconde barre auxiliaire (652), lesdites secondes barres supports (651) étant connectées à ladite seconde barre omnibus (62) et s'étendant à partir de là vers ladite première barre omnibus (61), chacune desdites secondes barres supports (651) ayant une première extrémité (653) qui est connectée à ladite seconde barre omnibus (62), et une seconde extrémité (654) qui est opposée à ladite première extrémité (653) de ladite seconde barre support (651), ladite seconde barre auxiliaire (652) interconnectant lesdites secondes extrémités (654) desdites secondes barres supports (651);
dans laquelle ladite première barre d'interconnexion intérieure (645) interconnecte deux adjacentes desdites premières barres supports (641) et est espacée de ladite première barre omnibus (61) dans la seconde direction (52) par une distance inférieure à la distance entre ladite première barre auxiliaire (642) et ladite première barre omnibus (61) dans la seconde direction (52); et
dans laquelle ladite seconde barre d'interconnexion intérieure (655) interconnecte deux adjacentes desdites secondes barres supports (651) et est espacée de ladite seconde barre omnibus (62) dans la seconde direction (52) par une distance inférieure à la distance entre ladite seconde barre auxiliaire (652) et ladite seconde barre omnibus (62) dans la seconde direction (52).

10. Cellule solaire (3) de la revendication 9, dans laquelle toutes les deux adjacentes desdites premières barres supports (641) sont espacées l'une de l'autre dans la première direction (51) par une distance (d1), et toutes les deux adjacentes desdites secondes barres supports (651) sont espacées l'une de l'autre dans la première direction (51) par la distance (d1), lesdites secondes extrémités (644) desdites premières barres supports (641) étant alignées sur une autre le long d'une première ligne (L1), lesdites secondes extrémités (654) desdites secondes barres supports (651) étant alignées sur une autre le long d'une seconde ligne (L2) qui est parallèle à ladite première ligne (L1), lesdites première et seconde lignes (L1, L2) étant espacées l'une de l'autre par une distance (d2), dans laquelle d1 ≥ d2 > 100 µm.

11. Cellule solaire (3) de la revendication 9, dans laquelle ladite première barre d'interconnexion intérieure (645) et ladite seconde barre d'interconnexion intérieure (655) sont alignées l'une sur l'autre dans la seconde direction (52).

12. Cellule solaire de la revendication 9, dans laquelle ladite première barre d'interconnexion intérieure (645) et ladite seconde barre d'interconnexion intérieure (655) sont désalignées l'une par rapport à l'autre dans la seconde direction (52).

13. Cellule solaire (3) selon l'une quelconque des revendications 9 à 12, dans laquelle chacune desdites premières et secondes barres supports (641, 651) a une longueur X dans la seconde direction (52), ladite première barre d'interconnexion intérieure (645) ayant deux extrémités opposées qui sont disposées entre et qui sont connectées à deux adjacentes desdites premières barres supports (641), et étant espacée de ladite seconde extrémité (644) de chacune desdites deux adjacentes desdites premières barres supports (641) dans la seconde direction (52) par une distance (d3), dans laquelle X/2 ≥ d3 ≥ X/3, ladite seconde barre d'interconnexion (655) ayant deux extrémités opposées qui sont disposées entre et qui sont connectées à deux adjacentes desdites secondes barres supports (651), et étant espacée de ladite seconde extrémité (654) de chacune desdites deux adjacentes desdites secondes barres supports (651) dans la seconde direction (52) par une distance (d4), dans laquelle X/2 ≥ d4 ≥ X/3.

14. Cellule solaire (3) de la revendication 9, dans laquelle chacune desdites première et seconde barres omnibus (61, 62) a des première et seconde extrémités (611, 612, 621, 622) opposées, ladite couche d'électrode avant (6) comprenant en outre une première barre latérale de connexion (81) qui s'étend dans la seconde direction (52) et qui interconnecte lesdites premières extrémités (611, 621) desdites première et seconde barres omnibus (61, 62), et une seconde barre latérale de connexion (82) qui est espacée de et qui est parallèle à ladite première barre latérale de connexion (81) et qui interconnecte lesdites secondes extrémités (612, 622) desdites première et seconde barres omnibus (61, 62).

15. Cellule solaire (3) de la revendication 9, dans laquelle chacune desdites première et seconde barres omnibus (61, 62) a des première et seconde extrémités (611, 612, 621, 622) opposées, ladite couche d'électrode avant (6) comprenant en outre deux premières barres latérales de connexion (83) qui s'étendent dans la seconde direction (52) et qui sont espacées l'une de l'autre et qui sont alignées l'une sur l'autre dans la seconde direction (52), et deux secondes barres latérales de connexion (84) qui sont espacées l'une de l'autre et qui sont alignées l'une sur l'autre dans la seconde direction (52), lesdites secondes barres latérales de connexion (84) étant parallèles auxdites et étant espacées desdites premières barres latérales de connexion (83), lesdites premières barres latérales de connexion (83) étant connectées auxdites premières extrémités (611, 621) desdites première et seconde barres omnibus (61, 62), respectivement, lesdites secondes barres latérales de connexion (84) étant connectées auxdites secondes extrémités (612, 622) desdites première et seconde barres omnibus (61, 62), respectivement.

16. Module à cellule(s) solaire(s) comprenant:
des premier et second panneaux (1, 2) opposés qui sont espacés l'un de l'autre;
au moins une cellule solaire (3) telle que définie dans l'une quelconque des revendications 9 à 15, ladite cellule solaire (3) étant disposée entre lesdits premier et second panneaux (1, 2); et
un boîtier (4) disposé entre lesdits premier et second panneaux (1, 2) et renfermant ladite cellule solaire (3).
